# EUROPÄISCHE PATENTSCHRIFT

(11) **EP 2 304 076 B1**
(45) Veröffentlichungstag und Bekanntmachung des Hinweises auf die Patenterteilung: **19.09.2012**
(21) Anmeldenummer: 09780214.4
(22) Anmeldetag: 07.07.2009
(51) Int. Cl.: C23C 16/513, C23C 16/04

(54) **VERFAHREN ZUR INNENBESCHICHTUNG VON HOHLKÖRPERN MIT EINEM PLASMASTRAHL BEI ATMOSPHÄRENDRUCK**
PROCESS FOR THE INTERNAL COATING OF HOLLOW BODIES USING A PLASMA BEAM AT ATMOSPHERIC PRESSURE
PROCÉDÉ DE REVÊTEMENT DE L'INTÉRIEUR DE CORPS CREUX PAR JET DE PLASMA SOUS PRESSION ATMOSPHÉRIQUE

(30) Priorität: 18.07.2008 DE 102008033939
(43) Veröffentlichungstag der Anmeldung: 06.04.2011
(73) Patentinhaber: Innovent e.V., 07745 Jena (DE)
(72) Erfinder: PFUCH, Andreas, 99510 Apolda (DE); DRÖßLER, Michael, 30989 Gehrden (DE); HORN, Kerstin, 07749 Jena (DE); HEFT, Andreas, 07545 Gera (DE)
(74) Vertreter: Liedtke, Markus
(86) Internationale Anmeldenummer: PCT/EP2009/058549
(87) Internationale Veröffentlichungsnummer: WO 2010/006951

(56) Entgegenhaltungen:
- WO-A-01/55489
- WO-A-02/071438
- WO-A-2006/096255
- WO-A-2007/022976
- WO-A1-2006/048649
- US-A- 4 292 342
- US-A1- 2004 173 316

## Beschreibung

Die Erfindung betrifft ein Verfahren zur Innenbeschichtung eines Hohlkörpers.

Die Beschichtung von Oberflächen mit dünnen, insbesondere im Nanometerbereich liegenden, funktionellen Schichten unter Verwendung eines Plasmas ist seit langem bekannt. Dabei werden unterschiedliche Gasentladungen unter Vakuumbedingungen eingesetzt. Man unterscheidet zwischen physikalischer und chemischer Gasphasenabscheidung.

Eine besondere Herausforderung stellt die Innenbeschichtung von Rohrmaterial durch eine plasmagestützte chemische Gasphasenabscheidung dar.

Aus der DE 10 2005 040 266 A 1 ist ein Verfahren zur Innenbeschichtung von Hohlkörpern bekannt, bei dem in einer Reaktorkammer ein Behandlungsbereich wenigstens teilweise evakuiert, ein Prozessgas in den Behandlungsbereich, insbesondere in den Hohlkörper eingeleitet und mittels eingestrahlter elektromagnetischer Energie ein Plasma in dem im Behandlungsbereich eingeleiteten Prozessgas gezündet wird. Dabei durchströmt das Prozessgas während der Plasmabehandlung den Behandlungsbereich zwischen gegenüberliegenden Enden.

Aus der US 2002/0058143 A1 ist ein verbrennungsbasiertes Verfahren zur chemischen Dampfabscheidung (CCVD) bekannt, bei dem das Innere eines Hohlkörpers durch Einführen eines Flammenbrenners beschichtet wird.

Aus der DE 10 2006 012 021 A1 ist ein Verfahren zur Innenbeschichtung einer hohlen Endlosgeometrie bekannt, wobei ein mindestens einen Presursor enthaltendes Gasgemisch in die Endlosgeometrie eingeführt wird, wobei die Endlosgeometrie durch mindestens eine Elektrodeneinheit hindurchgeführt wird, wobei eine wechselnde elektrische Spannung an die Elektrodeneinheit angelegt wird, wobei im Bereich der Elektrodeneinheit das Gasgemisch zumindest teilweise in den Plasmazustand überführt wird, wobei durch das Plasma ein Reaktionsprodukt aus dem Precursor erzeugt und auf der Innenfläche abgeschieden wird.

Aus der US 2003/0215644 A1 ist ein Verfahren bekannt, bei dem feinverteilte Aerosole von Polymerlösungen auf ein Substrat aufgebracht werden, wobei gleichzeitig eine Energiequelle auf die Lösung angewandt wird.

Aus der JP 04124273 A ist ein CVD-Verfahren bekannt, bei dem das Innere eines Rohres evakuiert und ein Trägergas mit gasförmigen Rohmaterialien eingebracht wird. Mittels Bogenentladung wird ein Plasma generiert und durch zentrischaxiale Führung mittels Magentfeldanordnungen zwecks CVD-Abscheidung durch das Innere des Rohres geführt.

Aus der DE 197 26 443 A 1 ist ein Verfahren zur Oberflächenvergütung innerer Oberflächen von Hohlkörpern mit zumindest einer Öffnung bekannt, bei dem der Hohlkörper von innen durch eine Hohlkathodenglimmentladung als Anregungsquelle vergütet wird, und durch einen durch den Hohlkörper strömenden Gasstrom aus einem bei der Hohlkathodenglimmentladung sich bildenden Plasma Teilchen herausgelöst, angeregt und zu der inneren Oberfläche des Hohlkörpers transportiert werden und dort den Vergütungsprozess auslösen, wobei der Hohlkörper in einem Vakuumgefäss angeordnet wird, und der Hohlkörper und die Hohlkathode voneinander getrennte Elemente bilden.

Aus der US 4,292,342 ist ein Verfahren bekannt, bei dem polycristallines Silizium auf der Innenfläche eines geformten Behälters abgeschieden wird. Das Silizium wird durch Reaktion von Wasserstoff und eines siliziumhaltigen Gases in Gegenwart eines Hochtemperaturplasmas abgeschieden. Der Siliziumkörper wird vom geformten Behälter mittels durch thermische Expansion erzeugter Scherbelastung abgelöst.

Aus der WO 02/071438 A ist eine Plasma-Behandlungs-Apparatur für ein Werkstück bekannt. Die Plasma-Behandlungs-Apparatur umfasst eine Metallelektrode, ein kapillares Dielektrikum mit ersten und zweiten Seiten, das mit der ersten Seite mit der Metallelektrode verbunden ist, wobei das kapillare Dielektrikum mindestens eine Kapillare aufweist. Ein Schirmkörper umgibt die Metallelektrode und die erste Seite des kapillaren Dielektrikums. Der Schildkörper weist erste und zweite Endabschnitte auf. Eine Gasversorgung versorgt die Metallelektrode mit Gas.

Aus der US 2004/173316 A1 ist bekannt, reaktive Atom-Plasma-Behandlung (RAP) zum Formen, Polieren, Einebenen und Entfernen unerwünschter Substanzen von Oberflächen unter minimaler Beschädigung der Oberflächenunterlage zu verwenden. Das RAP-Gerät verwendet eine Quelle zur Erzeugung durch Mikrowellen induzierten Plasmas (MIP) statt eines herkömmlichen ICP-Brenners (induktiv gekoppeltes Plasma), um diese Oberflächen zu modifizieren. Die Verwendung von MIP bewirkt einen geringeren Platzbedarf, feiner detaillierte, einfachere und verbesserte Bewegungsmöglichkeiten, geringere Wärmebelastung, verminderte Abschirmungserfordernisse sowie billigere Konstruktion und Bedienung als bei ICP.

Aus der WO 2007/022976 A ist ein Verfahren zur Plasmabehandlung von Werkstücken bekannt, insbesondere von Hohlkörpern. Gemäß dem Verfahren wird ein Behandlungsbereich in einer Reaktorkammer zumindest teilweise evakuiert, ein Prozessgas wird in den Behandlungsbereich eingeleitet, insbesondere in den Hohlkörper des Werkstücks. Ein Plasma wird im in den Behandlungsbereich eingebrachten Prozessgas gezündet, indem elektromagnetische Energie darin eingestrahlt wird. Das Prozessgas strömt während der Plasmabehandlung durch den Behandlungsbereich zwischen gegenüberliegenden Enden des Bereiches.

In der WO 2006/096255 A ist eine metallische, mit Nanopartikeln beschichtete, thermoplastische Schicht und ein Verfahren zu deren Herstellung offenbart.

Aus der WO 01/55489 A ist eine Schicht bekannt, die chemisch, mechanisch und/oder optisch schützende Eigenschaften hat oder eine Diffusionsbarriere bildet und auf einem Metall- oder Plastik-Substrat abgeschieden ist. Die Schichten bestehen aus einer organischen Schicht-Matrix mit darin verteilten metallhaltigen Partikeln. Die metallhaltige organische Schicht wird ausgehend von mindestens einem Kohlenwasserstoff, der substituiert werden kann und einer metallhaltigen Komponente plasma-polymerisiert. Die Schutz- und/oder Diffusionsbarriere-Schicht wird in einer Dicke im Submikronbereich verwendet und enthält darin fein verteilte Metallpartikel, die eine Korngröße von weniger als 50 % der Schichtdicke aufweisen. Die organische Schicht-Matrix wird durch Plasma-Polymerisation aus einem Prozessgas oder einem anorganischen Gas in einem evakuierbaren Reaktor abgeschieden, wobei das Prozessgas mindestens einen Kohlenwasserstoff, der auch substituiert werden kann und eine metallhaltige Komponente umfasst. Während des Prozesses können organische Monomere mit unterschiedlichen Polaritäten und/oder metallhaltige Komponenten mit unterschiedlichen Konzentrationen in den Reaktor eingebracht werden. Die Schutz - und/oder Diffusionsbarriere-Schicht wird beispielsweise als Antikorrosionsschicht auf Metallsubstraten oder als flexible Diffusionsschicht mit einstellbarer elektrischer Leitfähigkeit auf Plastikverpackungen verwendet. Das Verfahren eignet sich unter anderem zum elektrisch leitfähigen Beschichten von Fasern, Whiskern und Stäben.

Aus der zwischen veröffentlichten WO 2009/128880 A1 ist ein Apparat zur internen plasmaunterstützten Gasphasenabscheidung zur Herstellung von Silizium-Dünnschicht-Solarzell-Modulen bekannt. Der Apparat umfasst Mittel zum Halten eines Substrats. Das Substrat hat eine äußere Oberfläche und eine innere Oberfläche. Plasmabrenner-Mittel sind in der Nähe der inneren Oberfläche angeordnet um mindestens eine Dünnfilmschicht auf der inneren Oberfläche des Substrats abzuscheiden. Die Plasmabrenner-Mittel sind mit einem Abstand vom Substrat angeordnet. Es sind Mittel zu Versorgung der Plasmabrenner-Mittel mit reagenten Chemikalien angeordnet. Mindestens eine Dünnfilmschicht bildet die Silizium-Dünnschicht-Solarzell-Module.

Aus der WO 2006/048649 A 1 ist bekannt, ein nicht im thermischen Gleichgewicht befindliches Atmosphärendruckplasma, umfassend ein zerstäubtes Mittel zur Oberflächenbehandlung durch Anlegen einer hochfrequenten Hochspannung an eine in einem dielektrischen Gehäuse befindliche Elektrode zu erzeugen, wobei ein Prozessgas zwischen einem Einlass des Gehäuses an der Elektrode vorbei zum Auslass des Gehäuses zum Fließen gebracht wird. Die angelegte Spannung ist ausreichend hoch, um ein nicht im thermischen Gleichgewicht befindliches Atmosphärendruckplasma zwischen der Elektrode und zumindest dem Auslass des Gehäuses zu erzeugen. Die Elektrode kann mit einem Zerstäuber für das Mittel zur Oberflächenbehandlung innerhalb des Gehäuses kombiniert sein. Die Elektrode kann ein radioaktives Material umfassen. Die zu behandelnde Oberfläche kann in der Nähe des Plasma-Auslasses positioniert sein, so dass die Oberfläche im Kontakt mit dem Plasma ist. Die Oberfläche kann relativ zum Plasma-Auslass bewegt werden.

Der Erfindung liegt die Aufgabe zu Grunde, ein verbessertes Verfahren zur Innenbeschichtung von Hohlkörpern anzugeben.

Die Aufgabe wird erfindungsgemäß durch die in Anspruch 1 angegebenen Merkmale gelöst.

Vorteilhafte Ausgestaltungen der Erfindung sind Gegenstand der Unteransprüche.

Bei einem erfindungsgemäßen Verfahren zur Innenbeschichtung eines Hohlkörpers wird aus einem Arbeitsgas ein Plasmastrahl erzeugt. Dabei wird mindestens ein Precursormaterial dem Arbeitsgas und/oder dem Plasmastrahl zugeführt und im Plasmastrahl zur Reaktion gebracht. Dies bewirkt eine Abscheidung mindestens eines Reaktionsproduktes mindestens eines der Precursoren auf einer Innenfläche des Hohlkörpers und/oder auf mindestens einer auf einer Innenfläche angeordneten Schicht. Das erfindungsgemäße Verfahren wird bei Atmosphärendruck durchgeführt, wobei der Plasmastrahl durch eine erste Öffnung des Hohlkörpers eingeleitet wird.

In einer bevorzugten Ausführungsform wird der Plasmastrahl durch eine zweite Öffnung des Hohlkörpers abgesaugt. Durch die Absaugung an der zweiten Öffnung des Hohlkörpers kann der Plasmastrahl durch den gesamten Hohlkörper geleitet werden, was eine besonders homogene Aktivierung bzw. Beschichtung in Längsrichtung des Hohlkörpers ermöglicht.

Durch das Arbeiten bei Atmosphärendruck wird auf besonders vorteilhafte Weise ein zeitaufwändiger Prozessschritt der Evakuierung einer Prozesskammer sowie Apparaturen zur Vakuumerzeugung, wie Vakuumpumpen und Prozesskammer, eingespart. Dadurch lässt sich das erfindungsgemäße Verfahren ohne großen Aufwand in eine Prozesskette integrieren, die eine Herstellung und Vergütung des Hohlkörpers beinhaltet. Eine solche Art der Beschichtung ist mit einem Plasmabrenner mit geringem Leistungseintrag (beispielsweise 100 W bis 200 W) realisierbar.

In einer nicht erfinderischen Ausführungsform findet vor einem Beschichtungsprozess ein Aktivierungsprozess statt, bei dem der Plasmastrahl ohne Zufuhr eines Precursormaterials in den Hohlkörper eingebracht wird. Dadurch wird die innere Oberfläche des Hohlkörpers gereinigt und aktiviert, was eine bessere Haftung anschließend aufgebrachter Schichten zur Folge hat.

Erfindungsgemäß findet die erste Innenbeschichtung direkt im Anschluss an einen Herstellungsprozess des Hohlkörpers, bei dem der Hohlkörper unter Hitzezufuhr gebildet wurde, statt. Dadurch kann der Aktivierungsschritt eingespart werden.

Vorteilhafter Weise rotiert der Hohlkörper während des Beschichtungsprozesses um eine Längsachse, um eine homogene Beschichtung der Innenfläche des Hohlkörpers zu erzielen.

Die Homogenität der Beschichtung kann auch durch eine Rotation eines Plasmabrenners erreicht werden.

Vorzugsweise ist eine Außenelektrode des Plasmabrenners derart ausgestaltet, dass sie oder er durch die erste Öffnung in Richtung der Längsachse des Hohlkörpers eingeführt werden kann.

Der Beschichtungsprozess umfasst einen oder mehrere Beschichtungsdurchläufe, bei denen die Außenelektrode des Plasmabrenners vorzugsweise in den Hohlkörper eingeführt und in dessen Längsrichtung bewegt wird, so dass der Hohlkörper einmal oder mehrmals hintereinander von innen beschichtet wird.

Mit diesem Beschichtungsprozess lassen sich Hohlkörper aus einem der Stoffe Glas, Kunststoff, Metall und Keramik beschichten, insbesondere Spritzenkörper aus Glas.

Bei Hohlkörpern aus Glas gelingt es mit dem Verfahren, SiO₂-Schichten im Inneren der Glas-Hohlkörper abzuscheiden und damit eine Alkalidiffusion aus dem Glas in ein bei der Nutzung des Hohlkörpers im Hohlkörper befindliches Füllmedium, beispielsweise bidestilliertes Wasser, signifikant zu reduzieren.

Eine Temperatur des Hohlkörpers liegt bei diesem Beschichtungsprozess in einem Bereich von 20 °C bis 200 °C, bevorzugt in einem Bereich von 20°C bis 120°C, besonders bevorzugt in einem Bereich von 20°C bis 80°C.

Mit dem Verfahren können in der Schicht beispielsweise mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden werden. Für die Abscheidung von Silizium-, Titan- und/oder Aluminiumoxidschichten werden vorzugsweise silizium-, titan- und/oder aluminiumorganische Verbindungen als Precursoren verwendet. Solche Schichten sind besonders als Barriereschutzschichten oder Kratzschutzschichten geeignet.

Diese Precursoren können in fester, flüssiger und/oder gasförmiger Form vorliegen, wobei feste und flüssige Precursoren vor dem Einleiten in das Arbeitsgas oder den Plasmastrahl zweckmäßigerweise in den gasförmigen Zustand überführt werden.

Vorzugsweise können silberhaltige Nanopartikel und/oder Silber als Nanopartikel Bestandteil eines Precursors sein. Auf diese Weise lassen sich beispielsweise SiO₂-Schichten mit silberhaltigen Nanopartikeln ausbilden, mit denen eine bakterizide Schicht realisierbar ist.

Ein Durchsatz des Arbeitsgases und/oder des Precursors ist bevorzugt variabel und steuerbar und/oder regelbar.

Weiterhin kann die Geschwindigkeit, mit der der Plasmabrenner in den Hohlkörper eingeführt und bewegt wird, variabel und steuerbar und/oder regelbar sein. Neben dem Durchsatz des Arbeitsgases und/oder des Precursors steht so ein weiteres Mittel zur Beeinflussung der Schichteigenschaften, wie beispielsweise der Schichtdicke, zur Verfügung. Durch geeignete Wahl dieser Prozessparameter und der verwendeten Precursoren sind beispielsweise folgende Eigenschaften des Substrats gezielt veränderbar: Kratzfestigkeit, Selbstheilungsfähigkeit, Reflexionsverhalten, Transmissionsverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität.

Besonders bevorzugt wird mindestens eine der abgeschiedenen Schichten als Diffusionsbarriere gegenüber mindestens einem Alkalielement, beispielsweise Natrium oder Kalium, und/oder gegenüber mindestens einem Erdalkalielement, beispielsweise Magnesium oder Kalzium, und/oder gegenüber Bor und/oder insbesondere gegenüber Wolfram ausgeführt.

Bei der Herstellung von Spritzenkörpern aus Glas schafft ein Wolframdorn die Austrittsöffnung der Spritze, wonach Wolfram und Wolframoxid an der noch hei-βen Oberfläche des Innenbereichs der Austrittsöffnung zurückbleiben. Diese Fremdstoffeinträge sind wegen Wechselwirkungen mit Medikamenten unerwünscht und können zum Beispiel durch eine Diffusionsbarriere daran gehindert werden, in das Füllmedium des Spritzenkörpers überzugehen, um pharmazeutisch festgelegte Maximal-Konzentrationen von Wolfram im Füllgut nicht zu überschreiten.

Das Verfahren ist jedoch nicht auf die Beschichtung von Spritzenkörpern beschränkt. Vielmehr kann es auch für andere Hohlkörper, insbesondere Rohre und andere Endlosmaterialien beliebiger Größe, beispielsweise für Pipelines, verwendet werden.

Weiterhin stellt mindestens eine der abgeschiedenen Schichten eine Diffusionsbarriere gegenüber mindestens einem der Stoffe Sauerstoff, Wasser, Wasserdampf und/oder organischen Lösemitteln, insbesondere aus Kunststoffen dar.

In einer Ausgestaltung der Erfindung wird mindestens eine Gradientenschicht auf die Innenseite des Hohlkörpers aufgebracht. Als Gradientenschicht soll eine Schicht verstanden werden, deren Zusammensetzung sich über ihre Dicke allmählich ändert. Der Begriff wird in Abgrenzung zu benachbarten Schichten mit verschiedenen Eigenschaften verwendet, die eine klare Grenze aufweisen.

Als Arbeitsgas kann ein Gas oder Aerosol, vorzugsweise Luft, Sauerstoff, Stickstoff, Edelgase, Wasserstoff, Kohlendioxid, gasförmige Kohlenwasserstoffe, Ammoniak oder ein Gemisch wenigstens zweier der vorgenannten Gase verwendet werden. Ammoniak eignet sich beispielsweise zur Bildung von Nitriden und kann eine katalytische Wirkung bei der Umsetzung des Precursors aufweisen.

Die Zündung des Plasmas kann beispielsweise mittels Hochfrequenzanregung induktiv oder kapazitiv oder mittels Mikrowellenstrahlung erfolgen.

Eine Vorrichtung zur Durchführung des Verfahrens umfasst einen Plasmabrenner, der in eine erste Öffnung in Längsrichtung des Hohlkörpers eingeführt wird. Weiterhin umfasst die erfindungsgemäße Vorrichtung eine Absaugeinrichtung, die an eine zweite Öffnung des Hohlkörpers angeschlossen ist, wobei durch die erste Öffnung des Hohlkörpers ein Plasma unter Atmosphärendruck eingeleitet und durch die zweite Öffnung des Hohlkörpers abgesaugt wird.

In einer Ausführungsform der Erfindung sind der Plasmabrenner und/ oder der Hohlkörper rotierbar angeordnet.

Weiterhin ist der Plasmabrenner in Richtung der Längsachse des Hohlkörpers beweglich und in den Hohlkörper einführbar angeordnet, wobei eine Vorschubgeschwindigkeit eingestellt werden kann.

Gemäß einer weiteren Ausführungsform kann für jeden Beschichtungsdurchlauf eine konstante oder variable Vorschubgeschwindigkeit eingestellt werden.

Gemäß einer weiteren Ausführungsform kann der Gasfluss in Abhängigkeit von der Vorschubgeschwindigkeit des Plasmabrenners und/oder in Abhängigkeit der Position des Plasmabrenners eingestellt werden.

Um die Qualität der abgeschiedenen Schicht abzuschätzen, kann vor der eigentlichen Funktionsschicht eine Markerschicht abgeschieden werden, die einen Markerstoff enthält, der durch Lichtbestrahlung angeregt werden kann, um aus der Lichtverteilung des Markerstoffs auf die Homogenität der über der Markerschicht liegenden Funktionsschicht zu schließen. Der Markerstoff kann auch Bestandteil der Funktionsschicht sein.

Ausführungsbeispiele der Erfindung werden im Folgenden anhand einer Zeichnung näher erläutert.

Darin zeigt:

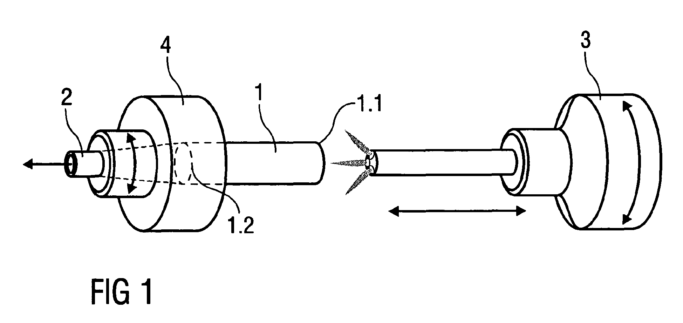

- Figur 1: eine schematische Darstellung einer Vorrichtung zur Innenbeschichtung eines Hohlkörpers mittels eines Plasmabrenners.

Figur 1 zeigt schematisch eine Vorrichtung zur Innenbeschichtung eines Hohlkörpers 1 mit einer Absaugeinrichtung 2 und einem Plasmabrenner 3. Der Plasmabrenner 3 wird in eine erste Öffnung 1.1 in Längsrichtung des Hohlkörpers 1 eingeführt. Die Absaugeinrichtung 2 ist an eine zweite Öffnung 1.2 des Hohlkörpers 1 angeschlossen. Dabei wird durch die erste Öffnung 1.1 des Hohlkörpers 1 ein Plasma unter Atmosphärendruck eingeleitet und das Plasma oder ein Reaktionsgas des Plasmas durch die zweite Öffnung 1.2 des Hohlkörpers 1 abgesaugt.

In einer anderen Ausführungsform kann statt eines Plasmabrenners 3 ein Flammenbrenner zur Innenbeschichtung des Hohlkörpers 1 verwendet werden.

Vor einem Beschichtungsprozess kann ein nicht erfindungsgemäβer Aktivierungsprozess stattfinden, bei dem der Plasmastrahl ohne Zufuhr eines Precursormaterials in den Hohlkörper 1 eingebracht wird.

Erfindungsgemäβ findet eine erste Innenbeschichtung direkt im Anschluss an einen Herstellungsprozess des Hohlkörpers 1, bei dem der Hohlkörper 1 unter Hitzezufuhr gebildet wurde, statt.

In einer Ausgestaltung der Erfindung kann der Hohlkörper 1 in einer Probenrotationseinrichtung 4 gehalten werden, so dass der Hohlkörper 1 während des Beschichtungsprozesses um eine Längsachse rotiert.

Weiterhin kann der Plasmabrenner 3 um eine Längsachse rotierend ausgeführt sein.

Vorzugsweise ist eine Außenelektrode des Plasmabrenners 3 derart ausgestaltet, dass sie durch die erste Öffnung 1.1 des Hohlkörpers 1 in Richtung der Längsachse des Hohlkörpers 1 eingeführt werden kann. Die Außenelektrode weist vorzugsweise radialsymmetrisch angeordnete Gasaustrittsöffnungen auf, um eine homogene Beschichtung des Hohlkörpers zu ermöglichen.

Die Plasmadüse ist vorzugsweise aus Metall gebildet, kann aber auch aus anderen Materialien, wie leitfähigen Keramiken gebildet sein.

Der Beschichtungsprozess kann einen oder mehrere Beschichtungsdurchläufe umfassen, bei denen die Außenelektrode des Plasmabrenners 3 in den Hohlkörper 1 eingeführt und in dessen Längsrichtung bewegt wird, so dass der Hohlkörper 1 einmal oder mehrmals hintereinander von innen beschichtet wird.

Es können Hohlkörper 1 aus einem der Stoffe Glas, Kunststoff, Metall und Keramik, insbesondere Spritzenkörper aus Glas, von innen beschichtet werden. Mit der abgeschiedenen Schicht können tribologische Eigenschaften zwischen dem Spritzenkörper und einem Spritzenkolben beeinflusst werden. Die Verwendung von Silikonöl zur Beeinflussung der tribologischen Eigenschaften ist bekannt. Durch die Schicht kann die Benetzbarkeit und somit die Verteilung des Silikonöls innerhalb der Spritze günstig beeinflusst werden. Gegebenenfalls kann durch eine geeignete Beschichtung gänzlich auf die Verwendung von Silikonöl verzichtet werden.

Eine Temperatur des Hohlkörpers 1 liegt bei diesem Beschichtungsprozess in einem Bereich von 20°C bis 200°C, bevorzugt bei 20°C bis 120°C, besonders bevorzugt bei 20°C bis 80°C.

Mit dem Verfahren können in der Schicht beispielsweise mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden werden. Für die Abscheidung von Silizium-, Titan- und/oder Aluminiumoxidschichten werden vorzugsweise silizium-, titan- und/oder aluminiumorganische Verbindungen als Precursoren verwendet.

Weiterhin können Nanopartikel, beispielsweise silberhaltige Nanopartikel und/oder Silber als Nanopartikel Bestandteil eines Precursors sein.

Der Precursor wird vorzugsweise gasförmig in ein Arbeitsgas oder in das Plasma eingebracht. Ist der Precursor flüssig oder fest, wird er bevorzugt vor dem Einleiten in das Arbeitsgas oder in den Plasmastrahl in den gasförmigen Zustand überführt.

Der Durchsatz des Arbeitsgases und/oder des Precursors ist variabel und steuerbar und/oder regelbar. Insbesondere sind die Durchsätze des Arbeitsgases und des Precursors unabhängig voneinander steuerbar und/oder regelbar.

Weiterhin ist die Geschwindigkeit, mit der der Plasmabrenner 3 in den Hohlkörper 1 eingeführt und darin bewegt wird, variabel und steuerbar und/oder regelbar.

Mittels mindestens einer der durch den beschriebenen Beschichtungsprozess abgeschiedenen Schichten lässt sich mindestens eine der Eigenschaften der Innenseite des Hohlkörpers 1 Kratzfestigkeit, Selbstheilungsfähigkeit, Reflexionsverhalten, Transmissionsverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität verändern.

Des Weiteren kann mindestens eine der abgeschiedenen Schichten als Diffusionsbarriere gegenüber mindestens einem Alkalielement, beispielsweise Natrium oder Kalium, und/oder gegenüber mindestens einem Erdalkalielement, beispielsweise Magnesium oder Kalzium, und/oder gegenüber Bor und/oder insbesondere gegenüber Wolfram ausgeführt sein.

Weiterhin kann zumindest eine der abgeschiedenen Schichten als Diffusionsbarrieren gegenüber mindestens einem der Elemente Sauerstoff, Wasserstoff, Wasserdampf und organische Lösemittel, insbesondere aus Kunststoffen fungieren.

In einer Ausgestaltung der Erfindung können Gradientenschichten auf die Innenseite des Hohlkörpers 1 aufgebracht werden.

Als Arbeitsgas kann ein Gas oder Aerosol, beispielsweise Luft, Sauerstoff, Stickstoff, Edelgase, Wasserstoff, Kohlendioxid, gasförmige Kohlenwasserstoffe, Ammoniak oder ein Gemisch wenigstens zweier der vorgenannten Gase verwendet werden.

Die Plasmadüse kann beispielsweise insgesamt dreimal in den Spritzenkörper ein - und ausgefahren werden. Beim ersten Einfahren wird dem Plasma kein Precursor zugesetzt. Stattdessen findet lediglich eine Aktivierung des Spritzenkörpermaterials zur Haftungsverbesserung statt. Anschließend wird die Plasmadüse einmal mit einem Durchsatz von 0,4 l/min des Precursors und einmal mit einem Durchsatz von 0,6 l/min eingefahren. Als Rotationsgeschwindigkeit der Düse werden beispielsweise 100 rpm gewählt. Eine Vorschubgeschwindigkeit der Plasmadüse liegt bei 50 mm/sec. Eine elektrische Leistung zur Plasmaerzeugung liegt bei etwa 100 W. Ein Gesamtgasfluss liegt bei ungefähr 34 l/min.

Die Absaugeinrichtung 2 ist optional und für das Verfahren nicht zwingend erforderlich. Es können auch Hohlkörper 1 beschichtet werden, die nur die erste Öffnung aufweisen und ansonsten geschlossen sind.

Das Verfahren kann auch für andere Hohlkörper 1, insbesondere Rohre und andere Endlosmaterialien beliebiger Größe, beispielsweise für Pipelines, verwendet werden.

Insbesondere zur Beschichtung von Rohren und anderem Endlosmaterial kann das Arbeitsgas mit dem Precursor in den Hohlkörper eingeleitet und das Plasma im Hohlkörper mittels von außerhalb des Hohlkörpers in den Hohlkörper eingekoppelter Energie gezündet werden.

Die Zündung des Plasmas kann beispielsweise mittels Hochfrequenzanregung induktiv oder kapazitiv oder mittels Mikrowellenstrahlung erfolgen.

### BEZUGSZEICHENLISTE

- 1: Hohlkörper
- 1.1 1: erste Öffnung
- 1.2: zweite Öffnung
- 2: Absaugung
- 3: Plasmabrenner
- 4: Probenrotationseinrichtung

## Patentansprüche

1. Verfahren zur Innenbeschichtung eines Hohlkörpers (1), bei dem aus einem Arbeitsgas ein Plasmastrahl erzeugt wird, wobei mindestens ein Precursormaterial dem Arbeitsgas und/oder dem Plasmastrahl zugeführt und im Plasmastrahl zur Reaktion gebracht wird, wobei der Plasmastrahl durch eine erste Öffnung (1.1) in einen Innenraum des Hohlkörpers (1) geleitet wird, wobei auf einer Innenfläche des Hohlkörpers (1) und/oder auf mindestens einer auf einer Innenfläche angeordneten Schicht mindestens ein Reaktionsprodukt mindestens eines der Precursoren abgeschieden wird, wobei das Verfahren bei Atmosphärendruck durchgeführt wird, **dadurch gekennzeichnet, dass** die erste Innenbeschichtung ohne einen Aktivierungsprozess und direkt im Anschluss an einen Herstellungsprozess des Hohlkörpers (1), bei dem der Hohlkörper (1) unter Hitzezufuhr gebildet wurde, stattfindet.

2. Verfahren nach Anspruch 1, **dadurch gekennzeichnet, dass** der Plasmastrahl und/oder Reaktionsgase des Plasmastrahls durch eine zweite Öffnung (1.2) des Hohlkörpers (1) abgesaugt werden.

3. Verfahren nach einem der vorhergehenden Ansprüche, **dadurch gekennzeichnet, dass** der Hohlkörper (1) während des Beschichtungsprozesses um eine Längsachse gedreht wird.

4. Verfahren nach einem der vorhergehenden Ansprüche, **dadurch gekennzeichnet, dass** ein den Plasmastrom emittierender Plasmabrenner (3) während des Beschichtungsprozesses um eine Längsachse rotiert wird.

5. Verfahren nach einem der vorhergehenden Ansprüche, **dadurch gekennzeichnet, dass** eine Außenelektrode eines den Plasmastrom emittierenden Plasmabrenners (3) verwendet wird, der derart ausgestaltet ist, dass sie/er durch die erste Öffnung (1.1) in Richtung der Längsachse des Hohlkörpers (1) einführbar ist.

6. Verfahren nach einem der vorhergehenden Ansprüche, **dadurch gekennzeichnet, dass** durch eine Absaugung (2) an der zweiten Öffnung (1.2) des Hohlkörpers (1) der Plasmastrahl durch den gesamten Hohlkörper (1) geleitet wird.

7. Verfahren nach einem der vorhergehenden Ansprüche, **dadurch gekennzeichnet, dass** der Beschichtungsprozess einen oder mehrere Beschichtungsdurchläufe umfasst, bei denen die Außenelektrode des Plasmabrenners (3) in den Hohlkörper (1) eingeführt und in dessen Längsrichtung bewegt wird, so dass der Hohlkörper (1) einmal oder mehrmals hintereinander von innen beschichtet wird.

8. Verfahren nach einem der vorhergehenden Ansprüche, **gekennzeichnet durch** die Beschichtung eines Hohlkörpers (1) aus einem der Stoffe Glas, Kunststoff, Metall und Keramik.

9. Verfahren nach einem der vorhergehenden Ansprüche, **dadurch gekennzeichnet, dass** als Hohlkörper (1) ein Spritzenkörper aus Glas beschichtet wird.

10. Verfahren nach einem der vorhergehenden Ansprüche, **dadurch gekennzeichnet, dass** eine Temperatur des Hohlkörpers (1) in einem Bereich von 20 C bis 200 °C liegt.

11. Verfahren nach einem der vorhergehenden Ansprüche, **dadurch gekennzeichnet, dass** in der Schicht mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden wird und/oder dass silberhaltige Nanopartikel und/oder Silber als Nanopartikel Bestandteil des Precursors sind.

12. Verfahren nach einem der vorhergehenden Ansprüche, **dadurch gekennzeichnet, dass** mittels mindestens einer der abgeschiedenen Schichten mindestens eine der Eigenschaften der Hohlkörperinnenseite Kratzfestigkeit, Selbstheilungsfähigkeit, Reflexionsverhalten, Transmissionsverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität verändert wird.

13. Verfahren nach einem der vorhergehenden Ansprüche, **dadurch gekennzeichnet, dass** mindestens eine der abgeschiedenen Schichten als Diffusionsbarriere gegenüber mindestens einem Alkalielement und/oder mindestens einem Erdalkalielement und/oder Bor und/oder Wolfram ausgeführt wird.

14. Verfahren nach einem der vorhergehenden Ansprüche, **dadurch gekennzeichnet, dass** mindestens eine der abgeschiedenen Schichten als Diffusionsbarriere gegenüber mindestens einem der Stoffe Sauerstoff, Wasser, Wasserdampf, Kohlendioxid und/oder organischen Lösemitteln, insbesondere aus Kunststoffen ausgeführt wird.

15. Verfahren nach einem der vorhergehenden Ansprüche, **dadurch gekennzeichnet, dass** als Hohlkörper ein Rohr oder ein Endlosmaterial beschichtet wird.

## Claims

1. Procedure for the interior coating of a hollow body (1) in which a plasma jet is generated from a working gas, in which at least one precursor material is fed to the working gas and/or to the plasma jet and made to react in the plasma jet, in which the plasma jet is conducted through a first opening (1.1) into an interior space of the hollow body (1), in which at least one reaction product of at least one of the precursors is deposited on an interior surface of the hollow-body (1) and/or on at least one layer arranged on an interior surface, in which the procedure is carried out at atmospheric pressure, **characterized in that** the first interior coating takes place without an activation process and directly subsequent to a manufacturing process of the hollow body (1) in which the hollow body (1) has been formed while introducing heat.

2. Procedure as claimed in claim 1, **characterized in that** the plasma jet and/or reaction gasses of the plasma jet are extracted through a second opening (1.2) of the hollow body (1).

3. Procedure as claimed in any preceding claim, **characterized in that** the hollow body (1) is turned around a longitudinal axis during the coating process.

4. Procedure as claimed in any preceding claim, **characterized in that** a plasma torch (3) emitting the plasma jet is rotated around a longitudinal axis during the coating process.

5. Procedure as claimed in any preceding claim, **characterized in that** an outer electrode of a plasma torch (3) emitting the plasma jet is used which is designed such that it is introducible through the first opening (1.1) in the direction of the longitudinal axis of the hollow body (1).

6. Procedure as claimed in any preceding claim, **characterized in that**, by an extractor (2) at the second opening (1.2) of the hollow body (1), the plasma jet is conducted through the entire hollow body (1).

7. Procedure as claimed in any preceding claim, **characterized in that** the coating process comprises one or more coating pass(es) in which the outer electrode of the plasma torch (3) is introduced into the hollow body (1) and moved in the hollow body's longitudinal direction such that the hollow body (1) is coated from the inside one or several time(s) one after the other.

8. Procedure as claimed in any preceding claim, **characterized by** the coating of a hollow body (1) made of any one of the substances glass, synthetic material, metal and ceramics.

9. Procedure as claimed in any preceding claim, **characterized in that**, as a hollow body (1), a syringe barrel made of glass is coated.

10. Procedure as claimed in any preceding claim, **characterized in that** a temperature of the hollow body (1) is in a range of between 20°C and 200°C.

11. Procedure as claimed in any preceding claim, **characterized in that** at least one oxide and/or one nitride and/or one oxynitride of at least one of the elements silicon, titanium, aluminium, molybdenum, tungsten, vanadium, zirconium or boron is deposited in the layer and/or that argentiferous nanoparticles and/or silver as nanoparticles are components of the precursor.

12. Procedure as claimed in any preceding claim, **characterized in that**, using at least one of the layers deposited, at least one of the properties of the hollow-body inside, i.e., scratch resistance, self-healing capability, reflectivity, transmission behaviour, index of refraction, transparency, light scattering, electrical conductivity, friction, adhesion, hydrophilicity, hydrophobicity, oleophilicity, oleophobicity, surface tension, surface energy, anticorrosive effect, dirt-repelling effect, self-cleaning capacity, photocatalytic behaviour, antistress behaviour, wear performance, resistance to chemical attack, biocide behaviour, biocompatible behaviour, antibacterial behaviour, electrostatic behaviour, electrochromic activity, photochromic activity, and gas-chromatic activity is modified.

13. Procedure as claimed in any preceding claim, **characterized in that** at least one of the layers deposited is implemented as a diffusion barrier to at least one alkali element and/or at least one alkaline earth element and/or boron and/or tungsten.

14. Procedure as claimed in any preceding claim, **characterized in that** at least one of the layers deposited is implemented as a diffusion barrier to at least one of the substances oxygen, water, water vapour, carbon dioxide and/or organic solvents, including but not limited to substances consisting of synthetic materials.

15. Procedure as claimed in any preceding claim, **characterized in that** a pipe or a continuous material is coated as a hollow body.

## Revendications

1. Procédé de revêtement intérieur d'un corps creux (1), où un jet de plasma est généré à partir d'un gaz de travail, où au moins un matériau précurseur est amené vers le gaz de travail et/ou le jet de plasma et est sollicité en réaction dans le jet de plasma, où le jet de plasma est conduit par une première ouverture (1.1) dans un espace intérieur du corps creux (1), où au moins un produit de réaction d'au moins un des précurseurs est séparé sur une surface intérieure du corps creux (1) et/ou sur au moins une couche disposée sur une surface intérieure, ledit procédé étant exécuté sous pression atmosphérique, **caractérisé en ce que** le premier revêtement intérieur est effectué sans processus d'activation et directement à la suite d'un processus de fabrication du corps creux (1), où ledit corps creux (1) a été formé sous apport de chaleur.

2. Procédé selon la revendication 1, **caractérisé en ce que** le jet de plasma et/ou les gaz de réaction du jet de plasma sont aspirés par une deuxième ouverture (1.2) du corps creux (1).

3. Procédé selon l'une des revendications précédentes, **caractérisé en ce que** le corps creux (1) est tourné autour d'un axe longitudinal pendant le processus de revêtement.

4. Procédé selon l'une des revendications précédentes, **caractérisé en ce qu'**un brûleur de plasma (3) émettant le flux de plasma est mis en rotation autour d'un axe longitudinal pendant le processus de revêtement.

5. Procédé selon l'une des revendications précédentes, **caractérisé en ce qu'**une électrode extérieure d'un brûleur de plasma (3) émettant le flux de plasma est utilisée, laquelle est configurée de manière que ladite électrode/ledit flux puisse être introduit(e) par la première ouverture (1.1) dans la direction de l'axe longitudinal du corps creux (1).

6. Procédé selon l'une des revendications précédentes, **caractérisé en ce que** le jet de plasma est conduit au travers du corps creux (1) dans son ensemble au moyen d'une aspiration (2) sur la deuxième ouverture (1.2) du corps creux (1).

7. Procédé selon l'une des revendications précédentes, **caractérisé en ce que** le processus de revêtement comprend une ou plusieurs passes de revêtement où l'électrode extérieure du brûleur de plasma (3) est introduite dans le corps creux (1) et déplacée dans la direction longitudinale de celui-ci, de manière à revêtir de l'intérieur le corps creux (1) une ou plusieurs fois successivement.

8. Procédé selon l'une des revendications précédentes, **caractérisé par** le revêtement d'un corps creux (1) avec une matière parmi le verre, le plastique, le métal et la céramique.

9. Procédé selon l'une des revendications précédentes, **caractérisé en ce qu'**un corps de seringue en verre est revêtu en tant que corps creux (1).

10. Procédé selon l'une des revendications précédentes, **caractérisé en ce que** la température du corps creux (1) est comprise entre 20 °C et 200 °C.

11. Procédé selon l'une des revendications précédentes, **caractérisé en ce que** dans la couche est séparé au moins un oxyde et/ou un nitrure et/ou un oxynitrure d'au moins un des éléments que sont le silicium, le titane, l'aluminium, le molybdène, le tungstène, le vanadium, le zirconium ou le bore, et/ou **en ce que** des nanoparticules à teneur en argent et/ou de l'argent sous forme de nanoparticules sont des composants du précurseur.

12. Procédé selon l'une des revendications précédentes, **caractérisé en ce qu'**au moyen d'au moins une des couches séparées, est modifiée au moins une des propriétés de l'intérieur du corps creux que sont la résistance aux rayures, l'aptitude à l'auto-régénération, le comportement de réflexion, le comportement de transmission, l'indice de réfraction, la transparence, la diffusion lumineuse, la conductivité électrique, la friction, l'adhérence, l'hydrophilie, l'hydrophobie, l'oléophilie, l'oléophobie, la tension de surface, l'énergie superficielle, l'efficacité anticorrosive, la résistance aux salissures, l'aptitude à l'auto-nettoyage, le comportement photocatalytique, la résistance aux contraintes, la résistance à l'usure, la résistance chimique, le comportement biocide, la biocompatibilité, le comportement antibactérien, le comportement électrostatique, l'activité électrochrome, l'activité photochrome, et l'activité gazochrome.

13. Procédé selon l'une des revendications précédentes, **caractérisé en ce qu'**au moins une des couches séparées est exécutée comme barrière anti-diffusion par rapport à au moins un élément alcalin et/ou au moins un élément alcalino-terreux et/ou le bore et/ou le tungstène.

14. Procédé selon l'une des revendications précédentes, **caractérisé en ce qu'**au moins une des couches séparées est exécutée comme barrière anti-diffusion par rapport à au moins une des substances que sont l'hydrogène, l'eau, la vapeur d'eau, le dioxyde de carbone et/ou les solvants organiques, en particulier à partir de matières plastiques.

15. Procédé selon l'une des revendications précédentes, **caractérisé en ce qu'**un tube ou un matériau sans fin est revêtu en tant que corps creux.
